# EUROPEAN PATENT SPECIFICATION

(11) **EP 0 570 176 B1**
(45) Date of publication and mention of the grant of the patent: **05.08.1998**
(21) Application number: 93303586.7
(22) Date of filing: 10.05.1993
(51) Int. Cl.: G02F 1/1335

(54) **Liquid crystal display panel and process for production thereof**
Flüssigkristallanzeigetafel und Verfahren zu ihrer Herstellung
Panneau d'affichage à cristal liquide et son procédé de fabrication

(30) Priority: 11.05.1992 JP 143716/92
(43) Date of publication of application: 18.11.1993
(73) Proprietor: CANON KABUSHIKI KAISHA, Tokyo (JP)
(72) Inventor: Kurematsu, Katsumi, c/o Canon Kabushiki Kaisha, Ohta-ku, Tokyo (JP)
(74) Representative: Beresford, Keith Denis Lewis

(56) References cited:
- EP-A- 0 309 948
- US-A- 4 952 026
- PATENT ABSTRACTS OF JAPAN, vol. 16, no. 392 (E-1251) 20 August 1992; & JP-A-04 129 268

## Description

The present invention relates to a liquid crystal display device, and a process for producing the same, particularly a liquid crystal display device having an increased effective aperture rate by using micro-lenses, suitable for liquid crystal panel display, or liquid crystal display projection, etc.

Liquid crystal display panels using micro-lenses have been disclosed in e.g. Japanese Laid-Open Patent Application JP-A-57-157215, JP-A-60-26213 and JP-A-2-1816. In each of the liquid crystal display panels, a glass substrate having micro-lenses formed thereon is applied to a liquid crystal display panel or micro-lenses are directly formed on a liquid crystal display panel.

In conventional display panels, because of their production processes, an alignment between a photo-mask or light-interrupting mask for masking regions except for effective pixel regions and micro-lenses is required, and therefore a mask aperture designing including a tolerance for compensating for an alignment error is required so that incomplete masking of unnecessary light cannot be avoided.

A number of proposals for improving photomask alignment have been disclosed in the prior art. These are summarised below.

US Patent No. 4,952,026 discloses a masked microlens array substrate member in which aligned metal photomasks are produced on the microlens array surface and reverse surface of a substrate having interstitial regions of opaque material.

The photomask on the array surface is produced by depositing first a partially light transmissive metal layer and then a positive-type photosensitive resin layer thereupon, exposing the resin by light incident from the reverse surface of the substrate, developing the resin layer, etching away the metal layer parts exposed by the developed layer, and removing the residual parts of the resin layer. Alternatively, the metal photomask on the array surface is produced using a negative type photosensitive resin, exposing the resin using light incident from the reverse surface of the substrate, developing the resin, depositing photomask metal, and removing the residual resin and metal covering the resin. The photomask on the reverse surface of the substrate is then produced by covering the reverse surface of the substrate with a layer of negative type photosensitive resin, exposing the resin to light incident from the array surface of the substrate, developing the resin, depositing photomask metal, and removing the residual resin and metal covering the residual resin. In all cases the photomasks are of metal and steps of metal deposition and selective removal of metal are performed.

In EP-A-0309948 a metal photomask is provided on the microlens array surface of a substrate. This is produced by covering the array surface with a positive-type photosensitive resin, exposing the resin to light incident from the reverse surface of the substrate for a predetermined exposure period, developing the resin, depositing photomask metal, and removing the residual resin and lifting off the metal covering the residual resin. In this case light incident from the reverse surface is dispersed by the microlens array and resin covering the microlenses is exposed at a slower rate than the adjacent parts of the resin layer. Alternatively, the microlens array is covered with photomask metal, then covered with a negative type photosensitive resin, the resin is exposed by light incident from the reverse surface of the substrate, the resin is developed, the metal exposed by the developed resin is etched away and the residual resin is removed. In each case the photomasks are of metal and steps of metal deposition and selective removal of metal are performed.

The present invention is intended as an alternative solution to the problem of photomask alignment. It is provided as a solution that does not require steps of depositing and selectively removing metal.

A matrix type liquid crystal display device and a process for producing the same, each in accordance with the present invention, are defined in the appended claims.

A characteristic feature of the display device of the present invention is a photomask formed of retained positive type photosensitive resin provided on the surface of the substrate opposite the microlens array. This is produced by steps including exposing a layer of positive type photosensitive resin to light incident from the microlens array surface of the substrate.

The display device may be an active matrix type display device including thin film transistor active components for addressing respective pixel electrodes, on a second substrate.

The positive type photosensitive resin may include dye or pigment.

It is mentioned that it has been known to produce a substrate having a microlens array and a photomask of dyed positive type photosensitive resin. JP-A-4129268 discloses such a substrate with the photomask on the microlens array surface of the substrate. This is produced by providing a substrate with a covering of positive type photosensitive resin, covering the resin with a transparent layer of a second resin, producing a microlens array on the layer of second resin, removing the parts of the transparent layer of second resin by dry etching using the microlens array as a mask, and dyeing the parts of the positive type resin exposed by removal of the parts of the transparent layer.

Other features and advantages of the present invention will become more apparent upon a consideration of the following description of the preferred embodiments of the present invention taken in conjunction with the accompanying drawings.

### BRIEF DESCRIPTION OF THE DRAWINGS

Figure 1 is a partial sectional view for illustrating an embodiment of a liquid crystal display panel according to the invention.

Figures 2A - 2C are sectional views for illustrating an embodiment of the process for producing a photomask according to the invention.

Figures 3A and 3B are sectional views for illustrating another embodiment of the process for producing a photomask according to the invention.

### DESCRIPTION OF THE PREFERRED EMBODIMENTS

In the process according to the present invention, photolithographic exposure for providing a photomask is performed through micro-lenses, so that self-alignment or automatic alignment between the photomask and the micro-lenses is effected, whereby condensed light flux obtained through the microlenses and the apertures of the photomask are completely aligned and the masking or interruption of unnecessary light such as strayed light is performed effectively and in a very good manner.

In the present invention, the photomask may for example be composed from a positive-type photosensitive dyed or dyeable resin or a positive-type photosensitive resin containing a pigment dispersed therein. For example, in the case where a positive-type photosensitive dyed resin, such as a novolak resin-type photoresist, the photoresist film after photolithographic exposure may be dyed, e.g., with an anthraquinone-based black dye.

The micro-lenses used in the present invention may be of any type inclusive of a graded index-type (i.e., refractive index distribution-type) or resinous lenses comprising convexities.

Hereinbelow, the present invention will be described based on some embodiments.

### First embodiment

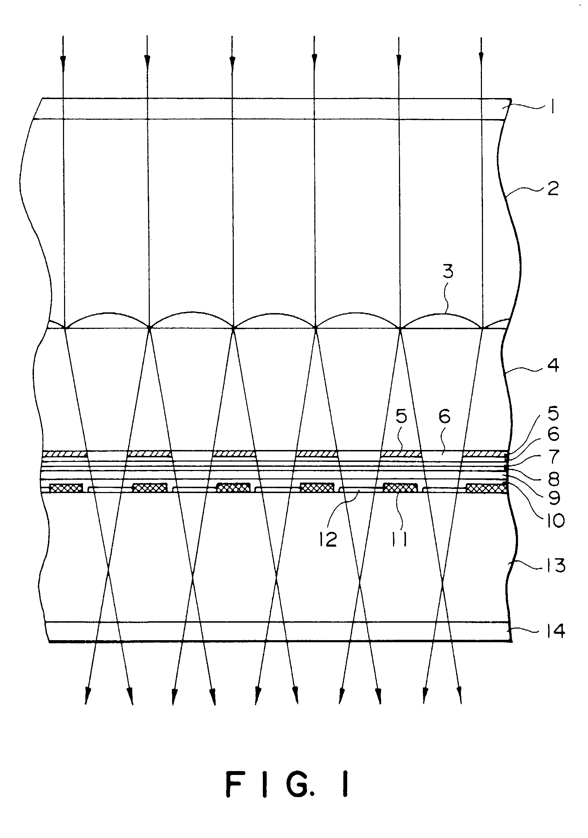

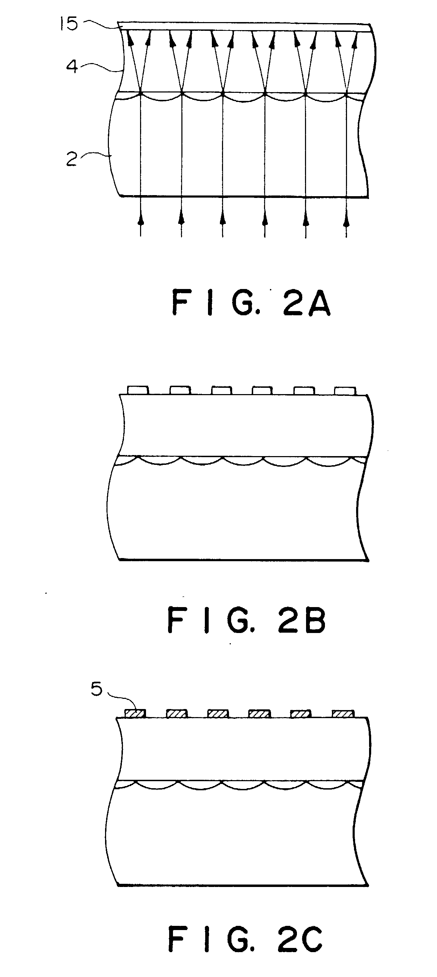

Figure 1 is a partial sectional view of a liquid crystal display panel produced by this embodiment, and Figures 2A - 2C are sectional views for illustrating a process for producing the photomask used therein. Referring to the figures, the liquid crystal display panel includes a counter glass substrate 4 on which a micro-lens glass substrate 2 is applied, a TFT glass substrate 13 having thin film transistors formed thereon, and a liquid crystal 9 disposed between the substrates 4 and 13. On the outer sides of the substrates are applied a pair of polarizers 1 and 14.

The production process is described below.
1) A glass substrate 4 and a glass substrate provided with graded index-type micro-lenses 3 are applied to each other, e.g., by hot pressing or using a heat-resistant adhesive.
2) The glass substrate 4 is coated by application with a positive-type photosensitive dyeable resin layer 15, which is then exposed to light through the micro-lenses 3 in a pattern corresponding to the condensation effected by the microlenses (as shown in Figure 2A).
3) The exposed resin layer 15 is then developed to leave a pattern as shown in Figure 2B by removing the parts exposed to the condensed light.
4) The resin pattern thus formed is dyed to form a photomask (pattern) 5 (Figure 2C).
5) The photomask (pattern) 5 is then coated with a top-coat layer 6 of e.g., an inorganic oxide, such as silica, or a resin, such as epoxy resin, acrylic resin or polyimide (Figure 1).
6) A counter electrode 7 of, e.g., ITO (indium tin oxide) is formed thereon, e.g., by sputtering.
7) An alignment film 8 is formed thereon, if necessary, followed by rubbing.
8) The counter substrate 4 thus formed is combined with a TFT glass substrate 13 provided with TFTs 11, pixel electrodes 12, data electrodes, scanning electrodes and an alignment film 10 to form a cell while alignment is effected so that the photomask 5 is aligned to mask the TFTs 11.
9) The cell is filled with a liquid crystal 9 and sealed up, and then polarizers 1 and 14 are applied on the outer sides.

In the liquid crystal display panel thus produced, the micro-lenses and the photomask are self-aligned so that light fluxes condensed by micro-lenses 3 as indicated by pairs of arrows in Figure 1 are completely aligned with the apertures 6 of the photomask 5. As a result, the interruption or masking of unnecessary light such as strayed light can be performed effectively and in a satisfactory manner.

In the above-embodiment, the micro-lens substrate 2 is applied onto the counter glass substrate 4. It is however also possible to apply the method of the above embodiment to production of a monolithic-type substrate wherein micro-lenses are directly formed on a counter glass substrate.

Further, the micro-lenses may be formed as a two-dimensional array of dot-type lenses or an array of cylindrical lenses.

### Second embodiment

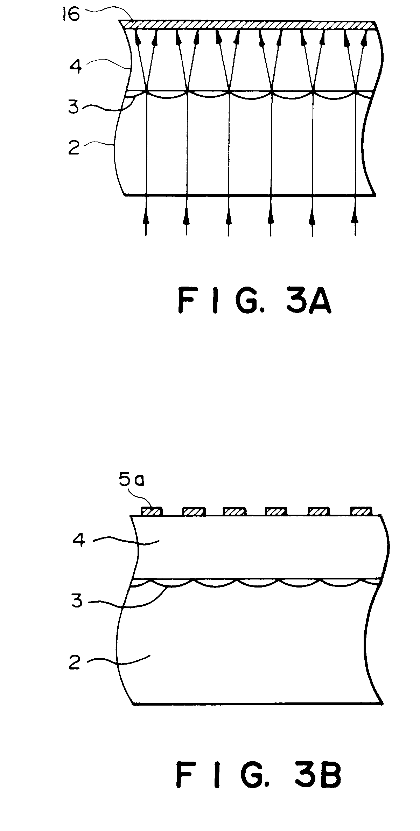

Figures 3A and 3B illustrate another embodiment process for production of a photo-mask to be included in a liquid crystal display panel having an entire structure identical to the one shown in Figure 1. The production process is described below.
1) A glass substrate 2 provided with graded index-type micro-lenses 3 and a glass substrate 4 are applied to each other, e.g., by hot-pressing or with a heat-resistant adhesive.
2) The glass substrate 4 is coated by application with a positive-type photosensitive resin layer 16 containing a pigment therein, and the photosensitive resin layer 16 is then exposed to light through the micro-lenses 3 in a pattern corresponding to the condensation effected by the micro-lenses (as shown in Figure 3A).
3) The exposed resin layer 16 is then developed to leave a photomask pattern 5a as shown in Figure 3B by removing the parts exposed to the condensed light.
4) The photomask (pattern) 5a is then coated with a top-coat layer 6 of e.g., an inorganic oxide, such as silica, or a resin, such as epoxy resin, acrylic resin or polyimide (Figure 1).
5) A counter electrode 7 of, e.g., ITO (indium tin oxide) is formed thereon, e.g., by sputtering.
6) An alignment film 8 is formed thereon, if necessary, followed by rubbing.
7) The counter substrate 4 thus formed is combined with a TFT glass substrate 13 provided with TFTs 11, pixel electrodes 12, data electrodes, scanning electrodes and an alignment film 10 to form a cell while alignment is effected so that the photomask 5 is aligned to mask the TFTs 11.
8) The cell is filled with a liquid crystal 9 and sealed up, and then polarizers 11 and 14 are applied on the outer sides.

In this way, a liquid crystal display panel having a structure as shown in Figure 1 having identical effects is produced through a production process including one step less than those involved in the first embodiment.

As described above, according to the present invention, photolithographic exposure for providing a photomask is performed through micro-lenses, so that the photomask and the micro-lenses are self-aligned, whereby condensed light flux and the aperture of the photomask are completely aligned and the masking of unnecessary light is performed effectively and in a satisfactory manner.

Further, the resultant liquid crystal display panel thus produced is caused to have an increased effective aperture rate, thus providing a clear image display.

## Claims

1. A matrix-type liquid crystal display device comprising:
first and second substrates (4,13) including electrodes (7,12) for defining display pixels;
a layer (9) of liquid crystal material disposed between said first and second substrates (4,13);
an array of micro-lenses (3), provided at a first principal surface of said first substrate (4), with each respective micro-lens (3) arranged for condensing incident light towards a respective one or more display pixels of said layer (9) of liquid crystal material; and
a photomask (5;5a), arranged on a second principal surface of said first substrate (4) opposite to said array of micro-lenses (3), which photomask (5;5a) consists of an apertured layer (15;16) made by photolithography from a positive-type photosensitive resin layer exposed through said array of micro-lenses, so that the apertures (6) of which are aligned with the condensed light flux obtained through said array of micro-lenses (3).

2. A display device according to claim 1, being an active matrix display device having respective thin film transistors (11) and respective pixel electrodes (12), arranged on said second substrate (13), for addressing respective display pixels.

3. A display device according to either preceding claim wherein said apertured layer (15) contains a dye.

4. A display device according to either claims 1 or 2 wherein said apertured layer (16) contains a dispersed pigment.

5. A process for producing the matrix-type liquid crystal display device of claim 1, which process comprises steps of:
providing a first substrate (4) having an array of micro-lenses (3) at a first principal surface thereof;
forming a layer (15;16) of positive-type photosensitive resin on a second principal surface of said first substrate (4), opposite to said array of micro-lenses (3);
exposing said layer (15;16) of positive-type photosensitive resin to light incident through and condensed by said array of micro-lenses (3); and
developing the exposed layer (15;16) of photosensitive resin to form a photomask (5;5a) thereof having apertures (6) which are aligned with the condensed light flux obtained through said array of micro-lenses (3).

6. A process according to claim 5 including a step of forming respective thin film transistors (11) and respective pixel electrodes (12) on a second substrate (13) for assembly with said first substrate (4) including said array of micro-lenses (3) and said photomask (5,5a).

7. A process according to either of claims 5 or 6 including a step of dyeing the exposed and developed layer (15) of photosensitive resin.

8. A process according to either of claims 5 or 6 wherein the layer (16) of positive-type photosensitive resin formed on said first substrate (4) includes dispersed pigment.

## Patentansprüche

1. Matrixtyp-Flüssigkristall-Anzeigenvorrichtung mit
ersten und zweiten Substraten (4,13), die Elektroden (7,12) zur Definition von Anzeigenbildelementen aufweisen,
einer Schicht (9) aus zwischen den ersten und zweiten Substraten (4,13) angeordnetem Flüssigkristallmaterial,
einer regelmäßigen Anordnung von Mikrolinsen (3), die auf einer ersten Hauptoberfläche des ersten Substrats (4) ausgebildet ist, wobei jede jeweilige Mikrolinse (3) zur Bündelung einfallenden Lichts in Richtung eines jeweiligen der oder mehrerer Anzeigenbildelemente der Schicht (9) aus Flüssigkristallmaterial angeordnet ist, und
einer Photomaske (5;5a), die auf einer zweiten Hauptoberfläche des ersten Substrats (4) gegenüber der regelmäßigen Anordnung von Mikrolinsen (3) angeordnet ist, wobei die Photomaske (5;5a) aus einer Schicht (15;16) mit Aperturen besteht, die photolithographisch aus einem lichtempfindlichen Positiv-Harz hergestellt wurde, wobei die Schicht durch die regelmäßige Anordnung von Mikrolinsen so belichtet wird, daß deren Aperturen (6) zu dem durch die regelmäßige Anordnung von Mikrolinsen (3) erhaltenen, gebündelten Lichtstrom ausgerichtet sind.

2. Anzeigenvorrichtung nach Anspruch 1, wobei die Vorrichtung als
eine Aktivmatrix-Anzeigenvorrichtung mit jeweiligen Dünnfilmtransistoren (11) und jeweiligen Bildelementelektroden (12) ausgebildet ist, die auf dem zweiten Substrat (13) zur Adressierung jeweiliger Anzeigenbildelemente angeordnet sind.

3. Anzeigenvorrichtung nach Anspruch 1 oder 2, wobei
die Schicht (15) mit Aperturen einen Farbstoff enthält.

4. Anzeigenvorrichtung nach Anspruch 1 oder 2, wobei
die Schicht (16) mit Aperturen dispergierte Pigmente enthält.

5. Verfahren zur Herstellung der Matrixtyp-Flüssigkristall-Anzeigenvorrichtung nach Anspruch 1, wobei das Verfahren die Schritte
Erzeugen eines ersten Substrats (4) mit einer regelmäßigen Anordnung von Mikrolinsen (3) auf dessen erster Hauptoberfläche,
Ausbilden einer Schicht (15;16) aus einem lichtempfindlichen Positiv-Harz auf einer zweiten Hauptoberfläche des ersten Substrats (4), gegenüber der regelmäßigen Anordnung von Mikrolinsen (3),
Belichten der Schicht (15;16) aus lichtempfindlichen Positiv-Harz mit Licht einfallend und gebündelt durch die regelmäßige Anordnung von Mikrolinsen (3) und
Entwickeln der belichteten Schicht (15;16) aus lichtempfindlichen Harz zu deren Ausbilden zu einer Photomaske (5;5a) mit Aperturen (6), die zu dem durch die regelmäßige Anordnung von Mikrolinsen (3) erhaltenen, gebündelten Lichtstrom ausgerichtet sind.

6. Verfahren nach Anspruch 5 mit einem Schritt
des Ausbildens von jeweiligen Dünnfilmtransistoren (11) und jeweiligen Bildelementelektroden (12) auf einem zweiten Substrat (13) zum Zusammenbauen mit dem, die regelmäßige Anordnung von Mikrolinsen (3) und die Photomaske (5;5a) aufweisenden, ersten Substrat (4).

7. Verfahren nach Anspruch 5 oder 6 mit einem Schritt
des Färbens der belichteten und entwickelten Schicht (15) aus lichtempfindlichem Harz.

8. Verfahren nach Anspruch 5 oder 6, wobei
die auf dem ersten Substrat (4) ausgebildete Schicht (16) aus lichtempfindlichen Positiv-Harz dispergierte Pigmente aufweist.

## Revendications

1. Dispositif d'affichage à cristal liquide du type matriciel comprenant :
des premier et second substrats (4, 13) comportant des électrodes (7, 12) pour définir des pixels d'affichage ;
une couche (9) de matériau de cristal liquide disposée entre lesdits premier et second substrats (4, 13) ;
un groupement de microlentilles (3), disposées sur une première surface principale dudit premier substrat (4), chaque microlentille respective (3) étant conçue pour condenser la lumière incidente vers un ou plusieurs pixels d'affichage respectifs de ladite couche (9) de matériau de cristal liquide ; et
un masque de photogravure (5 ; 5a) disposé sur une seconde surface principale dudit premier substrat (4) qui est opposée audit groupement de microlentilles (3), lequel masque de photogravure (5 ; 5a) est constitué d'une couche pourvue d'ouvertures (15 ; 16) faite par photolithographie à partir d'une couche de résine photosensible du type positif exposée à travers ledit groupement de microlentilles de façon que les ouvertures (6) de celles-ci soient alignées avec le flux lumineux condensé obtenu à travers ledit groupement de microlentilles (3).

2. Dispositif d'affichage selon la revendication 1, celui-ci étant un dispositif d'affichage à matrice active ayant des transistors à couches minces respectifs (11) et des électrodes de pixels respectives (12), agencés sur ledit second substrat (13), pour l'adressage de pixels d'affichage respectifs.

3. Dispositif d'affichage selon l'une quelconque des revendications précédentes, dans lequel ladite couche (15) pourvue d'ouvertures contient un colorant.

4. Dispositif d'affichage selon l'une ou l'autre des revendications 1 et 2, dans lequel ladite couche (16) pourvue d'ouvertures contient un pigment dispersé.

5. Procédé pour produire un dispositif d'affichage à cristal liquide du type matriciel selon la revendication 1, lequel procédé comprend les étapes qui consistent :
à utiliser un premier substrat (4) ayant un groupement de microlentilles (3) sur une première surface de celui-ci ;
à former une couche (15 ; 16) de résine photosensible du type positif sur une seconde surface principale dudit premier substrat (4), opposée audit groupement de microlentilles (3) ;
à exposer ladite couche (15 ; 16) de résine photosensible du type positif à de la lumière incidente à travers, et condensée par ledit groupement de microlentilles (3) ; et
à développer la couche exposée (15;16) de résine photosensible afin de former un masque de photogravure (5 ; 5a) de celle-ci ayant des ouvertures (6) qui sont alignées avec le flux lumineux condensé obtenu à travers ledit groupement de microlentilles (3).

6. Procédé selon la revendication 5, comportant une étape de formation de transistors à couches minces respectifs (11) et d'électrodes de pixels respectives (12) sur un second substrat (13) pour un assemblage avec ledit premier substrat (4), comportant ledit groupement de microlentilles (3) et ledit masque de photogravure (5,5a).

7. Procédé selon l'une quelconque des revendications 5 ou 6, comportant une étape consistant à colorer la couche (15) exposée et développée de résine photosensible.

8. Procédé selon l'une ou l'autre des revendications 5 ou 6, dans lequel la couche (16) de résine photosensible du type positif formée sur ledit premier substrat (4) contient un pigment dispersé.
